(19)

**Europäisches Patentamt**
**European Patent Office**
**Office européen des brevets**

(11) **EP 4 769 870 A1**

(12) **EUROPEAN PATENT APPLICATION**

(43) Date of publication:
**01.07.2026 Bulletin 2026/27**

(21) Application number: **25221362.4**

(22) Date of filing: **08.12.2025**

(51) International Patent Classification (IPC):
**H02J 3/46** *(2026.01)* **H02J 3/32** *(2026.01)*
**H02J 3/38** *(2026.01)*

(52) Cooperative Patent Classification (CPC):
**H02J 3/32; H02J 3/381; H02J 2101/24**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **27.12.2024 KR 20240198390**

(71) Applicant: **Hanwha Solutions Corporation**
**Jung-gu**
**Seoul 04541 (KR)**

(72) Inventors:
• **KIM, Byung Jun**
  **04541 Seoul (KR)**
• **JANG, Ju Hyeong**
  **04541 Seoul (KR)**
• **CHA, Jee Yoon**
  **04541 Seoul (KR)**

(74) Representative: **Mooser, Sebastian Thomas**
**Wuesthoff & Wuesthoff**
**Patentanwälte und Rechtsanwalt PartG mbB**
**Schweigerstraße 2**
**81541 München (DE)**

(54) **METHOD AND APPARATUS FOR CALCULATING LOAD POWER OF POWER SUPPLY SYSTEM**

(57) A method of calculating load power of a power supply system includes obtaining a measured value of grid power and a measured value of energy storage system power, computing an offset between the measured value of the grid power and the measured value of the energy storage system power by controlling output power of an energy storage system, and calculating the load power based on the measured value of the grid power, the measured value of the energy storage system power, and the offset.

FIG. 1

**Description**

BACKGROUND

1. Field

The present disclosure relates to a method and apparatus for calculating load power of a power supply system.

2. Description of the Related Art

In a power supply system including an energy storage system, a grid, and a load, information on power demanded/consumed by the load is essential to efficiently manage and distribute power.

For this purpose, a power measuring device, such as a current transformer (CT), may be separately installed in the load to measure power demanded/consumed by the load. However, in this case, there are disadvantages, such as increased installation costs, maintenance costs, and system complexity.

This description of the related art is technical information which was known by the inventors for deduction of the present invention or acquired during the deduction, and should not be considered as having necessarily been published before the pertinent application.

SUMMARY

A technical task to be addressed by the present invention is to provide a method and apparatus for calculating load power of a power supply system. Another technical task to be addressed by the present invention is to provide a computer-readable recording medium having recorded thereon a program for causing a computer to execute the method. Technical tasks to be addressed are not limited to those described above, and there may be other technical problems.

As a technical means for achieving the aforementioned technical task, a first aspect of the present disclosure may provide a method of calculating load power of a power supply system.

The method includes obtaining a measured value of grid power and a measured value of energy storage system power, computing an offset between the measured value of the grid power and the measured value of the energy storage system power by controlling output power of an energy storage system, and calculating the load power based on the measured value of the grid power, the measured value of the energy storage system power, and the offset.

A second aspect of the present disclosure may provide a computer-readable recording medium having recorded thereon a program for causing a computer to execute the method of the first aspect.

A third aspect of the present disclosure may provide a controller including a memory storing at least one program and a processor operating by executing the at least one program, wherein the processor is configured to obtain a measured value of grid power and a measured value of energy storage system power, compute an offset between the measured value of the grid power and the measured value of the energy storage system power by controlling output power of an energy storage system, and calculate the load power based on the measured value of the grid power, the measured value of the energy storage system power, and the offset.

Other methods and systems for realizing the present invention and computer-readable recording media having recorded thereon programs for causing a computer to execute the methods may be further provided.

Other aspects, features, and advantages than those described above will be clear from the accompanying drawings, the claims, and the detailed description below.

BRIEF DESCRIPTION OF THE DRAWINGS

The above and other aspects, features, and advantages of certain embodiments of the disclosure will be more apparent from the following description taken in conjunction with the accompanying drawings in which:

FIG. 1 is an example diagram schematically illustrating a power supply system;
FIG. 2 illustrates a power supply system according to an embodiment;
FIG. 3 illustrates a power supply system according to another embodiment;
FIG. 4 is a flowchart of a method of calculating load power of a power supply system, according to an embodiment;
FIG. 5 is a circuit diagram illustrating a method of calculating load power of a power supply system, according to an embodiment;
FIG. 6 is a circuit diagram illustrating a method of computing an offset, according to an embodiment;
FIG. 7 is a flowchart illustrating a method of computing an offset, according to an embodiment; and
FIG. 8 is a block diagram of a power calculation apparatus according to an embodiment.

DETAILED DESCRIPTION

The advantages and features of the present invention and the method for achieving them will become clear with reference to the embodiments described in detail below together with the drawings. However, the present invention is not limited to the embodiments presented below but may be implemented in various modes, and it is to be appreciated that all changes, equivalents, and substitutes that do not depart from the spirit and technical scope of the present invention are encompassed in the embodiments. The embodiments presented below are provided so that this disclosure will be complete and will fully convey the scope of the invention to one of ordinary skill in the art to which the present invention pertains. In the description of the present invention, certain detailed explanations of the related art are omitted when it is deemed that they may unnecessarily obscure the gist of the present invention.

With respect to the terms used to describe the embodiments, general terms which are currently and widely used are selected as much as possible. However, meanings of the terms can be changed according to intention, a judicial precedence, the appearance of new technology, and the like. In certain cases, a term which is not commonly used can be selected. In such a case, the meaning of the term will be described in detail at the corresponding portion in the description of the present disclosure. Therefore, the terms used in the specification should be defined based on the meaning of the terms and the overall content of the specification.

When it is said herein that a portion "includes" an element, another element may be further included, rather than excluding the existence of the other element, unless otherwise described. Terminology, such as "unit" or "module", used herein as a suffix indicates a unit that processes at least one function or operation and may be implemented by hardware, software, or a combination thereof.

While terms including ordinal numbers such as "first," "second," etc., may be used to describe various elements, such elements must not be limited to the above terms. The above terms may be used only to distinguish one element from another.

Some embodiments of the present disclosure may be described in terms of functional block components and various processing steps. Some or all of these functional blocks may be implemented by any number of hardware and/or software components configured to perform specific functions. For example, the functional blocks of the present disclosure may be implemented using one or more microprocessors or circuits for a given function. Also, for example, the functional blocks of the present disclosure may be implemented in various programming or scripting languages. The functional blocks may be implemented with algorithms that run on one or more processors. The present disclosure may also employ conventional techniques for electronic configuration, signal processing, and/or data processing. The terms "mechanism," "element," "unit," and "configuration" may be used in a broad sense and are not limited to mechanical and physical configurations.

Embodiments are described in detail with reference to the accompanying drawings. However, the embodiments may be implemented in various different forms and are not limited to the examples described herein.

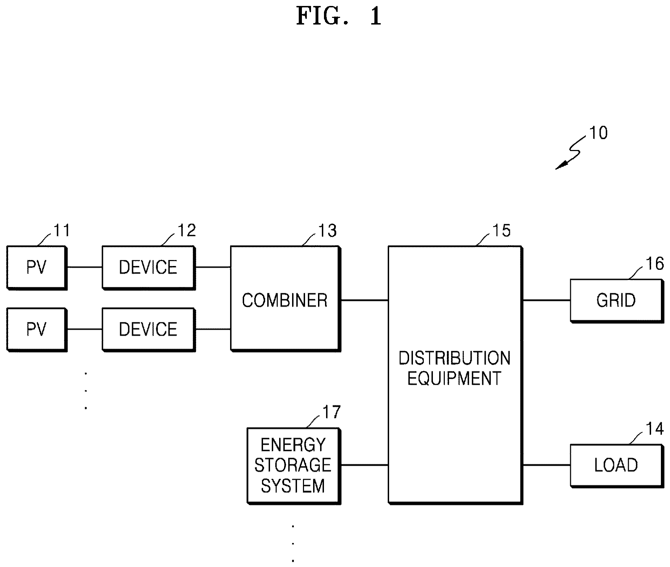

FIG. 1 is an example diagram schematically illustrating a power supply system.

Referring to FIG. 1, a power supply system 10 may include a photovoltaic module 11, a device 12, a load 14, and/or distribution equipment 15. The power supply system 10 may be connected to an external grid 16.

At least one photovoltaic module 11 may be installed on the roof or exterior wall of a building and may generate electricity. A plurality of photovoltaic modules 11 may be connected to form a photovoltaic module array.

The photovoltaic module 11 may be connected to the device 12. For example, at least one device 12 may be connected to each photovoltaic module 11. For example, when one device 12 is connected to each photovoltaic module 11, the number of devices 12 constituting the power supply system 10 may be the same as the number of photovoltaic modules 11.

The device 12 may correspond to a power conditioning system or power conversion system (PCS) that performs power conversion with respect to power generated from the photovoltaic module 11. For example, the device 12 may perform certain conversion on power generated from the photovoltaic module 11 and may supply converted power to other components (e.g., the grid 16 and/or the load 14) of the power supply system 10.

The device 12 may correspond to module level power electronics (MLPE). For example, the device 12 may be an optimizer or a microinverter (MI).

For example, when the device 12 is an optimizer, the device 12 may regulate power produced from the photovoltaic module 11 and output the power to an inverter (e.g., a string inverter). Current resulting from conversion (e.g., from direct current (DC) into alternating current (AC)) by the inverter may be output to the grid 16 or the load 14.

For example, when the device 12 is an MI, the device 12 may convert power generated from the photovoltaic module 11 (e.g., from DC to AC). The current converted by the device 12 may be output to the grid 16 or the load 14.

When necessary, the power supply system 10 may further include a combiner 13. At least some of the devices 12 may be connected to the distribution equipment 15 via the combiner 13. For example, power output from a plurality of devices 12 may be combined into one output by the combiner 13 and supplied to the distribution equipment 15.

The device 12 and the distribution equipment 15 may be connected to a power path that does not include the combiner 13. At least one device 12 may be connected to the distribution equipment 15 through a power path that does not include the combiner 13, and at least one other device 12 may be connected to the distribution equipment 15 via the combiner 13.

The combiner 13 may control voltage, current, and/or power output from the device 12 according to the power supply state of the photovoltaic module 11, the device 12, and/or the grid 16 and may set the operating mode thereof to a diagnosis mode, an operation mode, or the like.

The combiner 13 may include an energy management system (EMS) that controls the operation of the combiner 13. The EMS may control voltage, current, and/or power, which is supplied to or output from the combiner 13, according to the power supply state of the photovoltaic module 11, the device 12, and/or the grid 16 and may set the operating mode of the combiner 13 to the diagnosis mode, the operation mode, or the like.

The load 14 may refer to an object that is installed in an electricity consumer, such as a house, a commercial facility, or a factory, and operates by receiving at least one of energy generated by the photovoltaic module 11, energy stored in an energy storage system 17, and energy supplied from the grid 16. For example, when an electricity consumer supplied with power is a house, the load 14 may include a home appliance, such as a washing machine, a refrigerator, or a television (TV).

The grid 16 may include an infrastructure system for power generation, transmission, and distribution. For example, the grid 16 may include infrastructure systems, such as a power plant, a substation, and a power line. The grid 16 may transmit electric energy generated from a power plant to the power supply system 10 or transmit surplus power generated in the power supply system 10 to the outside of the power supply system 10.

For example, commercial power transmitted from the grid 16 through a power pole may be supplied to a power consumer through a transformer. The power supply system 10 may be implemented as an off-grid system that is not connected to the grid 16.

The power supply system 10 may further include at least one energy storage system 17. When necessary, the power supply system 10 may include a plurality of energy storage systems 17. The energy storage system 17 may receive and store power generated by the photovoltaic module 11 and/or power transmitted from the grid 16. The energy storage system 17 may efficiently supply power by storing power and supplying power to the load 14 when the load 14 needs the power.

The energy storage system 17 may include a battery that stores power and a power conversion module. The battery may be equipped with a battery management system (BMS), which monitors the state of charge (SOC), the state of health (SOH), the voltage, and/or the current of the battery, diagnoses the battery, and performs a safety function, such as current blocking.

The power conversion module may correspond to a PCS that performs conversion between a battery and power of a part opposite to the battery. For example, the PCS may perform conversion between DC of a battery and AC of an opposite part. For example, the PCS may include a bidirectional DC/DC converter, which is connected to a battery and converts voltage, and a bidirectional inverter, which connects the DC/DC converter to the outside of the energy storage system 17.

The energy storage system 17 may further include an EMS that controls the operation of the energy storage system 17. The EMS may control voltage, current, and/or power, which is supplied to or output from the energy storage system 17, according to the power supply state of a battery and/or the grid 16 and may set the operating mode of the energy storage system 17 to the diagnosis mode, the operation mode, or the like.

When necessary, an EMS coupled to a certain component of the power supply system 10 may control not only the operation of the certain component but also the operation of another component of the power supply system 10. For example, an EMS coupled to the combiner 13 or an EMS coupled to the energy storage system 17 may control the operations of both the combiner 13 and the energy storage system 17.

The distribution equipment 15 may provide electrical connection between components of the power supply system 10 and may control the power flow of the power supply system 10. For example, the distribution equipment 15 may electrically connect the photovoltaic module 11 to the load 14. For example, the distribution equipment 15 may be connected to the device 12 connected to the photovoltaic module 11 and may thus electrically connect the photovoltaic module 11 to the load 14. When necessary, the distribution equipment 15 may be further connected to at least one of the energy storage system 17 and the grid 16.

For example, the distribution equipment 15 may correspond to a distribution panel that distributes power in the power supply system 10. For example, the distribution equipment 15 may correspond to a master service panel (MSP) that distributes power generated from the photovoltaic module 11 to the load 14 or the like.

For example, the distribution equipment 15 may correspond to a main controller, which performs power distribution in the power supply system and controls each device 12. For example, the main controller may include a switch, a circuit breaker, and a control unit. The switch, the circuit breaker, and the control unit may each be implemented as an independent device, or at least some of the switch, the circuit breaker, and the control unit may be included in a single device.

The main controller may include a switch that controls electrical connections between components, such as the device 12 and the load 14, which are connected to the main controller. For example, the main controller may include a relay or a power semiconductor that provides or blocks electrical connection to the device 12 and/or the energy storage system 17 according to the driving state of each component of the power supply system 10.

The main controller may perform rapid shutdown to stop the power generation of the photovoltaic module 11 in an emergency situation, such as occurrence of overcurrent in the power supply system 10. For this operation, the main controller may include a circuit breaker that blocks the connection between the device 12 and the load 14.

The main controller may include a control unit that generally controls operations of the main controller. The control unit may also control operations of a component (e.g., the device 12 or the energy storage system 17) of the power supply system 10 other than the main controller.

The control unit may control voltage, current, and/or power, which is output from or supplied to each component, according to a power supply state of the photovoltaic module 11, the device 12, the combiner 13, the load 14, the grid 16, and/or the energy storage system 17. The control unit may also set the operating mode of the main controller, the device 12, and/or the energy storage system 17 to the diagnosis mode, the operation mode, or the like.

For example, the control unit may control the photovoltaic module 11, the device 12, the combiner 13, and/or the energy storage system 17, based on a state of the power supply system 10. For example, the control unit may enable the main controller to communicate with another component (e.g., the device 12) of the power supply system 10, thereby controlling another component of the power supply system 10. Communication between the main controller and another component of the power supply system 10 may be performed using power line communication (PLC) but is not limited thereto.

For example, the control unit may control the device 12 according to the power generation state of the photovoltaic module 11. For example, the main controller may receive a control command from a server that monitors the power generation state of the photovoltaic module 11, and the control unit may control the device 12 according to the control command.

The main controller may supply power to at least some of loads 14 when power supply from the grid 16 is not smooth (e.g., in an off-grid situation). For example, when the power supply from the grid 16 is not smooth, the main controller may preferentially supply power, which is generated from the photovoltaic module 11, and/or power, which is stored in the energy storage system 17, to a backup load that has a relatively high need for a stable power supply.

The power supply system 10 may further include an auxiliary power generation device (e.g., a diesel generator), which generates power in a separate manner other than solar power generation. For example, the auxiliary power generation device may be connected to the distribution equipment 15. When a backup load may not be handled by only the photovoltaic module 11 and the energy storage system 17 due to an environmental factor, such as a time zone or weather, the main controller may supply power generated by the auxiliary power generation device to the backup load.

The control unit may be implemented by at least one processor. A processor may process a command of a computer program by performing basic arithmetic, logic, and input/output operations. Here, the command may be provided from an internal memory of the main controller or from an external device. The processor may also generally control operations of other components included in the main controller.

The processor may perform at least some of data analysis, processing, and result information generation for performing the above-described operations by using at least one of machine learning, a neural network, or a deep learning algorithm, as a rule-based or artificial intelligence algorithm. Examples of neural networks may include models based on architecture, such as a convolutional neural network (CNN), a deep neural network (DNN), and a recurrent neural network (RNN).

For example, the processor may be implemented as an array of a number of logic gates or may be implemented as a combination of a general-purpose microprocessor and a memory storing a program that may be executed on the microprocessor. For example, the processor may include a general-purpose processor, a central processing unit (CPU), a microprocessor, a digital signal processor (DSP), a controller, a microcontroller, a state machine, or the like.

In some environments, the processor may include an application-specific integrated circuit (ASIC), a programmable logic device (PLD), a field programmable gate array (FPGA), or the like. For example, the processor may refer to a combination of processing devices, such as a combination of a DSP and a microprocessor, a combination of a plurality of microprocessors, a combination of one or more microprocessors in combination with a DSP core, or a combination of any other such components.

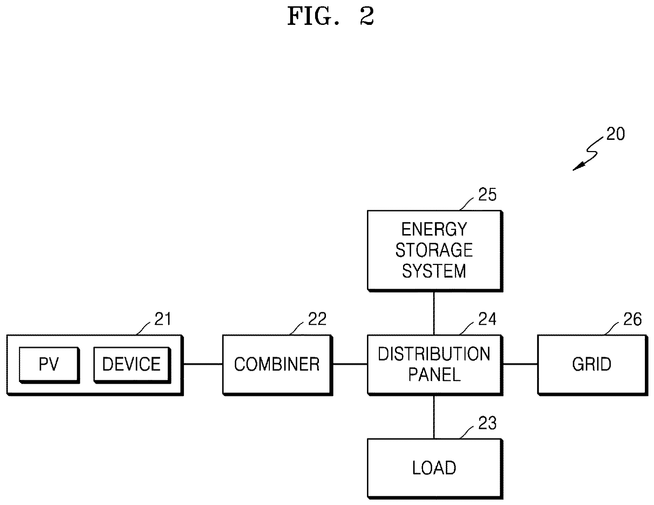

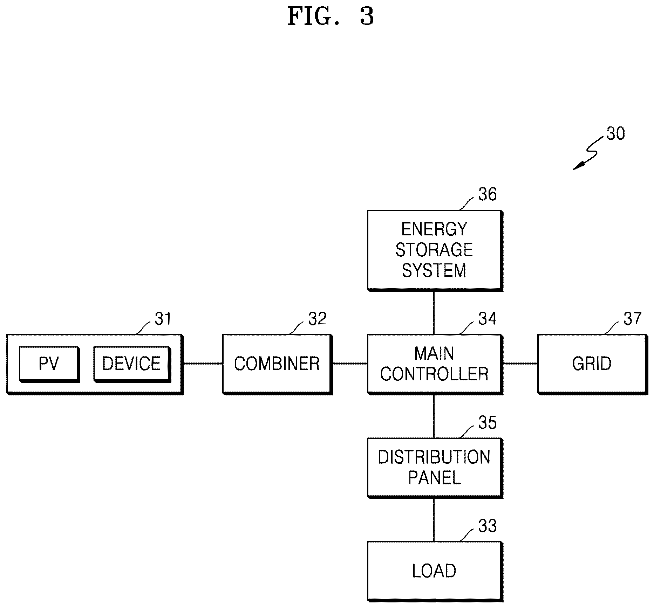

By combining at least some of the components described above, the power supply system 10 may be implemented in various forms. Hereinafter, various embodiments of the power supply system 10 will be described with reference to FIGS. 2 and 3. However, the implementation method of the power supply system 10 is not limited to the embodiment described below.

FIG. 2 illustrates a power supply system according to an embodiment.

Referring to FIG. 2, according to an embodiment, a power supply system 20 may include a photovoltaic system 21, a combiner 22, a load 23, a distribution panel 24, and an energy storage system 25. The power supply system 20 may be connected to an external grid 26.

In an embodiment, the energy storage system 25 may be connected to the distribution panel 24 and may be charged or discharged. In another embodiment, the energy storage system 25 may be connected to the combiner 22 and may be charged or discharged.

When the power supply system 20 further includes the energy storage system 25, power stored in the energy storage system 25 may be used to respond to the load 23 in a case where the load 23 may not be handled by the photovoltaic system 21 alone. When power generated by the photovoltaic system 21 exceeds the amount of power required to respond to the load 23, the excess may be stored in the energy storage system 25. When the charge amount of the energy storage system 25 is below a threshold and power generated by the photovoltaic system 21 does not exceed the amount of power required to respond to the load 23, the energy storage system 25 may be charged with power supplied from the grid 26.

Accordingly, the power supply system 20 may efficiently supply power to the load 23 by using the energy storage system 25.

The combiner 22 may perform control voltage, current, and/or power, which is output from the photovoltaic system 21, according to the power supply state of the photovoltaic system 21, the power supply state of the load 23, and/or the power supply state of the grid 26, and the operating mode of the combiner 22 may be set to the diagnosis mode, the operation mode, or the like.

In some embodiments, the energy storage system 25 may control voltage, current, and/or power, which is supplied to or output from the energy storage system 25, according to the power supply state of the photovoltaic system 21, the power supply state of the load 23, and/or the power supply state of the grid 26, and the operating mode of the energy storage system 25 may be set to the diagnosis mode, the operation mode, or the like.

In an embodiment, the power supply system 20 may further include a sub panel (not shown) connected to the distribution panel 24. In this case, at least one photovoltaic system 21 may be connected to the sub panel through the combiner 22, and at least one other photovoltaic system 21 may be directly connected to the sub panel.

In some embodiments, at least one energy storage system 25 may be connected to the combiner 22, the distribution panel 24, or the sub panel and thus be integrated into the power supply system 20.

At least one photovoltaic system 21 may be connected to the distribution panel 24 through a power path that does not include the combiner 22. For example, at least one photovoltaic system 21 may be connected to the distribution panel 24 through a power path that does not include the combiner 22, and at least one other photovoltaic system 21 may be connected to the distribution panel 24 via the combiner 22.

In an embodiment, at least one photovoltaic system 21 may be connected to the sub panel via the combiner 22, and at least one other photovoltaic system 21 may be directly connected to the sub panel.

The power supply system 20 may increase the total amount of power generated by the photovoltaic system 21, which may be integrated into the power supply system 20, by including a sub panel that provides additional power capacity.

FIG. 3 illustrates a power supply system according to another embodiment.

Referring to FIG. 3, according to an embodiment, a power supply system 30 may include a photovoltaic system 31, a combiner 32, a load 33, a main controller 34, a distribution panel 35, and an energy storage system 36. The power supply system 30 may be connected to an external grid 37.

The photovoltaic system 31, the combiner 32, the load 33, and the energy storage system 36 in FIG. 3 may respectively correspond to the photovoltaic system 21, the combiner 22, the load 23, and the energy storage system 25 in FIG. 2. The main controller 34 in FIG. 3 may correspond to the main controller described above with reference to FIG. 1.

The combiner 32 may electrically connect at least one photovoltaic system 31 to the main controller 34. For example, the combiner 32 may combine power output from at least one photovoltaic system 31 into one output and may supply the output to the main controller 34.

The main controller 34 may electrically connect the combiner 32, the distribution panel 35, and the grid 37 to one another. The main controller 34 may also connect the components described above to auxiliary power sources, such as the energy storage system 36 and/or an auxiliary power generator (e.g., a diesel generator, etc.). For example, the main controller 34 may output power supplied from the combiner 32 to the distribution panel 35, the energy storage system 36, and/or the grid 37. The main controller 34 may also output power supplied from the grid 37 to the distribution panel 35 or the energy storage system 36. The main controller 34 may also output power supplied from the energy storage system 36 to the distribution panel 35.

The distribution panel 35 may electrically connect the main controller 34 to at least one load 33. Accordingly, the power supply system 30 may supply power generated from the photovoltaic system 31 to the load 33 through the distribution panel 35.

The power supply system 30 may integrate a plurality of energy storage systems 36 and/or an auxiliary power generator into the power supply system 30 by including the main controller 34, thereby stably supplying power. In addition, the power supply system 30 may stably supply power to the load 33, such as a backup load, even in an off-grid environment where power may not be stably supplied from the grid 37.

The main controller 34 may control voltage, current, and/or power, which is output from or supplied to each component, according to the state of the photovoltaic system 31, the state of the load 33, the state of the energy storage system 36, and/or the state of the grid 37, and may set the operating mode of the main controller 34, the operating mode of the photovoltaic system 31, and/or the operating mode of the energy storage system 36 to the diagnosis mode, the operation mode, or the like.

In an embodiment, the power supply system 30 may further include a sub panel (not shown), which is connected to the main controller 34 and distinct from the distribution panel 35. In this case, at least one backup load having a relatively high need for stable power supply among a plurality of loads 33 may be connected to the sub panel, and at least one non-backup load having a relatively low need for stable power supply among the loads 33 may be connected to the distribution panel 35.

The main controller 34 may electrically connect the combiner 32, the distribution panel 35, the energy storage system 36, the grid 37, and the sub panel to one another. The main controller 34 may supply power, which is supplied from the combiner 32, the energy storage system 36, and/or the grid 37, to at least one non-backup load through the distribution panel 35 and to a backup load through a sub panel.

In an embodiment, the power supply system 30 may further include a sub panel, which is connected to the main controller 34 and distinct from the distribution panel 35, and the grid 37 may be connected to the distribution panel 35 instead of being connected to the main controller 34. That is, the main controller 34 may electrically connect the combiner 32, the distribution panel 35, the energy storage system 36, and the sub panel to one another, and the distribution panel 35 may electrically connect the main controller 34, the non-backup load, and the grid 37 to one another.

For example, the power supply system 30 may be implemented by connecting the main controller 34, which connects the combiner 32 to the energy storage system 36, to the distribution panel 35, which is pre-installed to connect at least one load 33 to the grid 37.

Accordingly, the power supply system 30 may stably supply power to the load 33, such as a backup load, even in an off-grid environment where power may not be stably supplied from the grid 37.

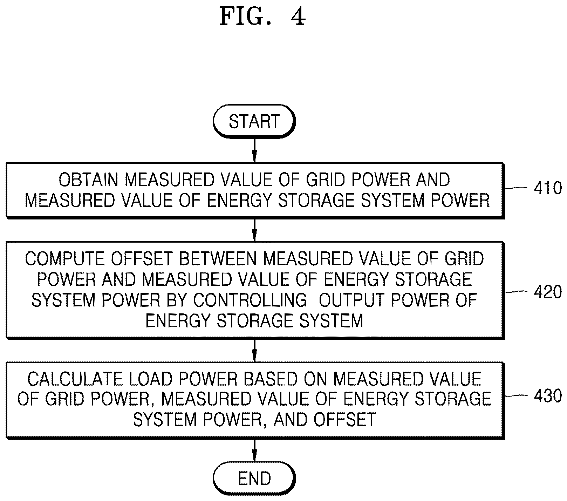

FIG. 4 is a flowchart of a method of calculating load power of a power supply system, according to an embodiment.

The method of FIG. 4 may be performed by a power calculation apparatus to be described below, and specifically, by a processor included in the power calculation apparatus.

The power calculation apparatus may obtain a measured value of grid power and a measured value of energy storage system power in operation 410.

In an embodiment, the power calculation apparatus may obtain a measured value of power output from a power conversion module included in the energy storage system.

In an embodiment, a power supply system may include a plurality of energy storage systems. In this case, the power calculation apparatus may obtain the measured value of the energy storage system power by adding up measured values of the power of the plurality of energy storage systems.

Alternatively, in an embodiment, each energy storage system included in the power supply system may include a plurality of ESS inverters. In this case, the power calculation apparatus may obtain the measured value of the energy storage system power by adding up measured values of the power of the plurality of ESS inverters. Here, an ESS inverter may refer to a power conversion module included in the energy storage system.

According to an embodiment, the power supply system may include at least one photovoltaic system. In this case, the power calculation apparatus may obtain a measured value of photovoltaic system power. Specifically, the power calculation apparatus may obtain a measured value of power output from an MI included in the photovoltaic system.

In an embodiment, the power supply system may include a plurality of photovoltaic systems. In this case, the power calculation apparatus may obtain the measured value of the photovoltaic system power by adding up measured values of the power of the plurality of photovoltaic systems.

In an embodiment, the power supply system may include a power measuring component, such as a current transformer (CT) or a voltage transformer (VT), for power measurement. Here, the CT (or the VT) may be connected to an end of a power measurement target. However, the component for power measurement is not limited to those mentioned above.

In an embodiment, the power calculation apparatus may be electrically connected to an end of each of an energy storage system, a grid, and a load. In this case, the power calculation apparatus may be configured to include a CT (or VT) for measuring energy storage system power and grid power. Specifically, the power calculation apparatus may be configured to include a CT (or VT), which is electrically connected to an end of a power conversion module included in the energy storage system and measures power output from the power conversion module.

In an embodiment, the power calculation apparatus may be electrically connected to an end of a photovoltaic system. In this case, the power calculation apparatus may be configured to include a CT (or VT) for measuring photovoltaic system power.

The power calculation apparatus may compute an offset between the measured value of the grid power and the measured value of the energy storage system power by controlling the output power of the energy storage system in operation 420.

In an embodiment, the "offset" may include a compensation value for correcting measurement errors in the measured value of the energy storage system power and the measured value of the grid power, signal noise, or asynchronization between CTs (or VTs) for measuring a power measurement value.

In an embodiment, the power calculation apparatus may determine an offset calculation function to dynamically compensate for the offset in response to a change in the measured value of the grid power, based on offsets at certain points. For example, the processor may obtain a first offset, a second offset, and a reference offset by controlling the output power of the energy storage system to a maximum output, a minimum output, and 0, respectively, and may compute a final offset based on the first offset, the second offset, and the reference offset.

Here, the "reference offset" may include a measured value of the grid power when the output power of the energy storage system is 0. The "first offset" may include the difference between the measured value of the grid power and the output power of the energy storage system when the output power of the energy storage system is at the maximum output. The "second offset" may include the difference between the measured value of the grid power and the output power of the energy storage system when the output power of the energy storage system is at the minimum output.

In an embodiment, the processor may determine a first offset calculation function to calculate the offset when the measured value of the grid power is a positive (+) value and a second offset calculation function to calculate the offset when the measured value of the grid power is a negative (-) value. For example, the processor may determine the first offset calculation function based on the first offset and the reference offset and may determine the second offset calculation function based on the second offset and the reference offset.

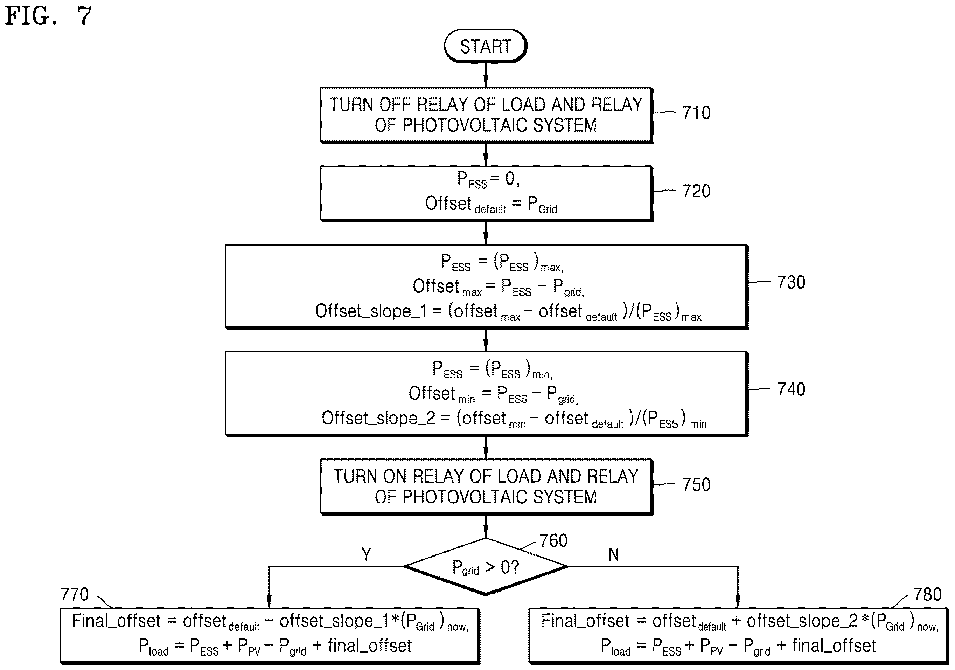

Specific details regarding the computation of the offset according to an embodiment will be described below in FIG. 7.

In an embodiment, the power supply system may include a switching element that establishes or breaks an electrical connection relationship between the power supply system and each of the photovoltaic system, the energy storage system, the load, and the grid. In this case, the power supply system may include a switching element that establishes or breaks the electrical connection relationship between the power supply system and an inverter included in the photovoltaic system or the energy storage system. Here, the switching element may include, but not limited to, an electrical switch such as a relay.

In an embodiment, the power calculation apparatus may include a circuit electrically connected to each of the photovoltaic system, the energy storage system, the grid, and the load, and a switching element may be included in the circuit of the power calculation apparatus. For example, the power calculation apparatus may be electrically connected to each of the photovoltaic system, the energy storage system, the grid, and the load. The switching element may be included in an internal circuit of the power calculation apparatus and may adjust an electrical connection relationship between the power supply system and each of the photovoltaic system, the energy storage system, the grid, and the load.

In an embodiment, the processor may further perform an operation of controlling at least one switching element included in the power supply system when computing the offset according to the method described above.

Specifically, the processor may compute the offset by controlling the output power of the energy storage system while disconnecting the electrical connection between the load and the power supply system and/or between the photovoltaic system and the power supply system by controlling the switching element. Accordingly, the influence of interference by the load may be excluded from the computation of the offset between the measured value of the grid power and the measured value of the energy storage system power. The influence of interference by the photovoltaic system, of which the output power varies with solar radiation, may also be excluded.

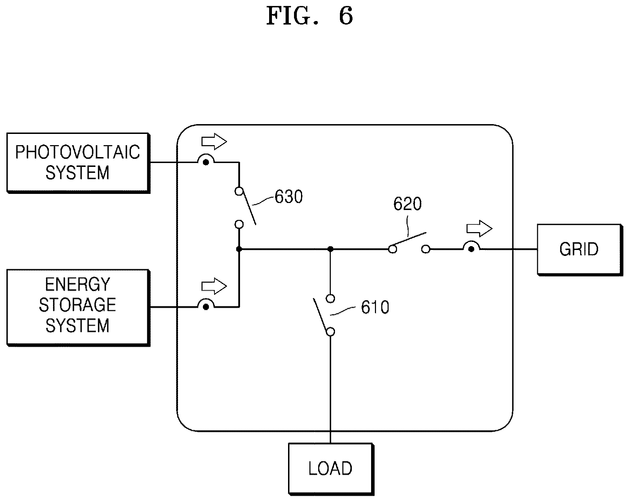

Specific details regarding switching element control in the process of computing the offset, according to an embodiment, will be described below in FIG. 6.

The power calculation apparatus may calculate the load power based on the measured value of the grid power, the measured value of the energy storage system power, and the offset in operation 430.

In an embodiment, the power calculation apparatus may calculate the load power based on a relationship among the energy storage system, the load, and the grid, which are included in the power supply system, and the offset computed in operation 420. For example, the power calculation apparatus may calculate the load power from the measured value of the energy storage system power and the measured value of the grid power by using a power conservation relationship among the energy storage system, the load, and the grid, which are included in the power supply system.

As described above, according to an embodiment, the power supply system may include a photovoltaic system. In this case, the power calculation apparatus may calculate the load power based on a relationship among the photovoltaic system, the energy storage system, the load, and the grid, which are included in the power supply system, and the offset computed in operation 420. For example, the power calculation apparatus may calculate the load power from the measured value of the energy storage system power and the measured value of the grid power by using a power conservation relationship among the photovoltaic system, the energy storage system, the load, and the grid, which are included in the power supply system,

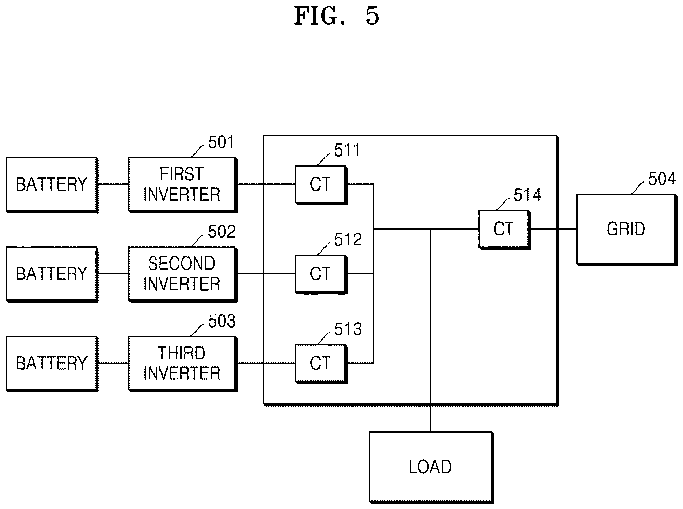

Specific details regarding the calculation of load power according to an embodiment will be described below in FIG. 5.

FIG. 5 is a circuit diagram illustrating a method of calculating load power of a power supply system, according to an embodiment.

Referring to FIG. 5, a circuit diagram of a power supply system including first to third inverters 501 to 503, CTs 511 to 513 respectively corresponding to the first to third inverters 501 to 503, a grid 504, and a CT 514 corresponding to the grid 504 is illustrated. Here, the first to third inverters 501 to 503 may each correspond to a power conversion module included in the energy storage system described above.

In an embodiment, the CT 511 may be electrically connected to an end of the first inverter 501 and may transmit a sensing signal of the first inverter 501 to a power measuring device. Similarly, the CT 512 and the CT 513 may be electrically connected to respective ends of the second inverter 502 and the third inverter 503, respectively, and may respectively transmit a sensing signal of the second inverter 502 and a sensing signal of the third inverter 503 to the power measuring device. In this case, the power measuring device may obtain measured values of power of the first to third inverters 501 to 503 based on the sensing signals respectively received from the CT 511, the CT 512, and the CT 513 and may add up the measured values to obtain a measured value of energy storage system power.

In an embodiment, the CT 514 may be electrically connected to an end of the grid 504 and may transmit a sensing signal of the grid 504 to the power measuring device. In this case, the power measuring device may obtain a measured value of the power of the grid 504 based on the sensing signal received from the CT 514.

In an embodiment, a power calculation apparatus may calculate a load power from a measured value of energy storage system power and a measured value of grid power, based on a power conservation relationship among the energy storage system power, the grid power, and the load power. Here, the power conservation relationship may be given by Equation 1 below.

## 【Equation 1】

$$P_{Load} = P_{ESS} - P_{Grid}$$

In Equation 1, $P_{Load}$ represents the load power, $P_{ESS}$ represents the energy storage system power, and $P_{Grid}$ represents the grid power. In an embodiment, based on Equation 1, the power calculation apparatus may calculate the load power from the measured value of the energy storage system power and the measured value of the grid power, which have been obtained.

In an embodiment, the power supply system may include at least one photovoltaic system. In this case, the power calculation apparatus may calculate the load power based on a power conservation relationship among photovoltaic system power, the energy storage system power, the grid power, and the load power. Here, the power conservation relationship may be given by Equation 2 below.

## 【Equation 2】

$$P_{Load} = P_{ESS} + P_{PV} - P_{Grid}$$

In Equation 2, $P_{Load}$ represents the load power, $P_{PV}$ represents the photovoltaic system power, $P_{ESS}$ represents the energy storage system power, and $P_{Grid}$ represents the grid power. In an embodiment, based on Equation 2, the power calculation apparatus may calculate the load power from the measured value of the energy storage system power, a measured value of the photovoltaic system power, and the measured value of the grid power, which have been obtained.

FIG. 6 is a circuit diagram illustrating a method of computing an offset, according to an embodiment.

Referring to FIG. 6, a power supply system is illustrated, wherein the power supply system includes a photovoltaic system, an energy storage system, a grid, a load, a load switching element 610, a grid switching element 620, and a photovoltaic system switching element 630.

As described above, in an embodiment, the power calculation apparatus may compute an offset between a measured value of grid power and a measured value of energy storage system power by controlling the output power of the energy storage system.

When the load is electrically connected to the power supply system, power consumption caused by the load may affect the measured value of the energy storage system power and/or the measured value of the grid power. Therefore, in an embodiment, the power calculation apparatus may disconnect the electrical connection between the load and the power supply system by controlling the load switching element 610 before computing the offset. In this case, the power calculation apparatus may compute the offset, which is described below, after forming the electrical connection between the grid and the power supply system by controlling the grid switching element 620.

Similarly, when a photovoltaic system is electrically connected to the power supply system, power output from the photovoltaic system may not be constant, which may affect offset computation. Therefore, in an embodiment, the power calculation apparatus may cut off the electrical connection between the photovoltaic system and the power supply system by controlling the photovoltaic system switching element 630 before performing the offset computation. In this case, the power calculation apparatus may perform the offset computation, which is described below, after forming the electrical connection between the grid and the power supply system by controlling the grid switching element 620.

Assuming that the electrical connection between the load and the power supply system and the electrical connection between the photovoltaic system and the power supply system are cut off by the power calculation apparatus controlling switching elements, the offset computation is described below.

In an embodiment, the power calculation apparatus may determine an offset calculation function to dynamically compensate for the offset in response to a change in the measured value of the grid power, based on offsets at certain points.

The power calculation apparatus may obtain a reference offset by controlling the output power of the energy storage system to 0. The power calculation apparatus may obtain a first offset by controlling the output power of the energy storage system to a maximum output. The power calculation apparatus may obtain a second offset by controlling the output power of the energy storage system to a minimum output.

Specifically, the reference offset may refer to the measured value of the grid power when the output power of the energy storage system is 0. For example, when the output power of the energy storage system is 0 W and the measured value of the grid power is -10 W, the reference offset may be -10 W.

The first offset may refer to the difference between the measured value of the grid power and a value of the output power of the energy storage system when the output power of the energy storage system has a positive (+) maximum value. For example, when the maximum output power of the energy storage system is +1000 W, the output power of the energy storage system is +1000 W, and the measured value of the grid power is +1020 W, the first offset may be +20 W.

The second offset may refer to the difference between the measured value of the grid power and the value of the output power of the energy storage system when the output power of the energy storage system has a negative (-) maximum value. For example, when the minimum output power of the energy storage system is -1000 W, the output power of the energy storage system is -1000 W, and the measured value of the grid power is -1030 W, the first offset may be -30 W.

The power calculation apparatus may calculate a first offset slope based on the reference offset and the first offset and may determine a linearized first offset calculation function. The power calculation apparatus may also calculate a second offset slope based on the reference offset and the second offset and may determine a linearized second offset calculation function. The power calculation apparatus may compute the offset by using the first offset calculation function when the measured value of the grid power is a positive (+) value or may compute the offset by using the second offset calculation function when the measured value of the grid power is a negative (-) value.

According to an embodiment, offset slopes and offset calculation functions may be calculated by using Equations 3 to 6 below.

【Equation 3】

$$Offset\_Slope\_1 = (Offset_{max} - Offset_{default})/ (P_{ESS})_{max}$$

【Equation 4】

$$Offset\_slope\_2 = (Offset_{min} - Offset_{default})/ (P_{ESS})_{min}$$

【Equation 5】

$$final\_Offset = Offset_{default} + Offset\_Slope\_1 \times P_{GRID\_now}$$

【Equation 6】

$$final\_Offset = Offset_{default} + Offset\_Slope\_2 \times P_{GRID\_now}$$

In Equations 3 to 6, $Offset_{default}$, $Offset_{max}$, and $Offset_{min}$ respectively represent the reference offset, the first offset, and the second offset. Offset_Slope_1 and Offset_Slope_2 respectively represent the slope of the first offset calculation function when the measured value of the grid power is positive (+) and the slope of the second offset calculation function when the measured value of the grid power is negative (-). $P_{Grid}$ refers to the measured value of the grid power.

In Equation 5, final_Offset represents the final offset when the measured value of the grid power is positive (+). In Equation 6, final_Offset represents the final offset when the measured value of the grid power is negative (-). That is, Equation 5 represents the first offset calculation function and Equation 6 represents the second offset calculation function.

In an embodiment, the power calculation apparatus may finally calculate the load power based on the measured value of the energy storage system power, the measured value of the grid power, and the offset computed by using the method described above.

According to an embodiment, based on the measured value of the grid power, the measured value of the energy storage system power, and the offset, the load power may be calculated using Equations 7 below.

【Equation 7】

$$P_{Load} = P_{ESS} - P_{Grid} + final\_Offset$$

In Equation 7, final_Offset may be calculated according to Equation 5(i.e. the first offset calculation function) described above when the measured value of the grid power is positive (+) and may be calculated according to Equation 6(i.e. the second offset calculation function) described above when the measured value of the grid power is negative (-).

In an embodiment, the power supply system may include at least one photovoltaic system. In this case, the power calculation apparatus may calculate the load power based on a power conservation relationship among photovoltaic system power, the energy storage system power, the grid power, and the load power.

According to an embodiment, based on the measured value of the grid power, the measured value of the energy storage system power, the measured value of the photovoltaic system power, and the offset, the load power may be calculated using Equations 8 below.

【Equation 8】

$$P_{Load} = P_{ESS} + P_{PV} - P_{Grid} + final\_Offset$$

In Equation 8, final_Offset may be calculated according to Equation 5(i.e. the first offset calculation function) described above when the measured value of the grid power is positive (+) and may be calculated according to Equation 6(i.e. the second offset calculation function) described above when the measured value of the grid power is negative (-).

For convenience of description, specific examples regarding the types, numbers, locations, and connection relationships of components included in a power supply system are illustrated, but the present disclosure is not limited thereto. In other words, a circuit of the power supply system may be changed by analogically applying the embodiments of a power calculation apparatus and a method of calculating load power of the power supply system, which are described in the present disclosure.

According to the embodiments described above, the accuracy of load power calculation may be increased by compensating in real time for offsets caused by factors, such as a measurement error occurring due to a precision limitation of measuring equipment, noise caused by electronic interference within a system, and residual impedance in a circuit of a power supply system. The accuracy of offset compensation may also be increased by subdivide a function to calculate the offset based on the charge/discharge state of a battery. Moreover, by controlling a switching element in a process of computing an offset, a consistent offset may be obtained while minimizing the impact of interference between a photovoltaic system and a load on the offset computation.

FIG. 7 is a flowchart of a method of computing an offset, according to an embodiment.

The method of FIG. 7 may be performed by a power calculation apparatus to be described below, and specifically, by a processor included in the power calculation apparatus.

The processor may control a load relay and a photovoltaic system relay in operation 710. Accordingly, the electrical connection between a power supply system and a load and the electrical connection between the power supply system and a photovoltaic system may be cut off.

The processor may control the output power of the energy storage system to 0, may obtain, as a reference offset, a measured value of grid power when the output power of the energy storage system is 0, and may store the reference offset in a memory included in the power calculation apparatus in operation 720.

The processor may control the output power of the energy storage system to a maximum output, may obtain, as a first offset, the difference between the measured value of the grid power and the output power of the energy storage system when the output power of the energy storage system is maximum, and may store the first offset in the memory included in the power calculation apparatus in operation 730. The processor may also calculate a first offset slope in a state where the grid power has a positive value based on the first offset and the reference offset value and may store the first offset slope in the memory included in the power calculation apparatus. Specifically, the processor may calculate the first offset slope by dividing the difference between the first offset and the reference offset by the maximum output power of the energy storage system.

The processor may control the output power of the energy storage system to a minimum output, may obtain, as a second offset, the difference between the measured value of the grid power and the output power of the energy storage system when the output power of the energy storage system is minimum, and may store the second offset in the memory included in the power calculation apparatus in operation 740. The processor may also calculate a second offset slope in a state where the grid power has a negative value based on the second offset and the reference offset and may store the second offset slope in the memory included in the power calculation apparatus. Specifically, the processor may calculate the second offset slope by dividing the difference between the second offset and the reference offset by the minimum output power of the energy storage system.

Although FIG. 7 illustrates a case where operation 730 is performed before operation 740, the present disclosure is not limited thereto. In other words, operation 740 may be performed before operation 730.

The processor may control the load relay and the photovoltaic system relay in operation 750. Accordingly, the electrical connection between the power supply system and the load and the electrical connection between the power supply system and the photovoltaic system may be formed.

The processor may determine whether the measured value of the grid power is positive (+) or negative (-) and may compute a final offset based on a result of the determination in operations 760 to 780. The processor may also calculate the load power based on the measured value of the grid power, the measured value of the energy storage system power, the measured value of the photovoltaic system power, and the final offset.

Specifically, when the measured value of the grid power is positive (+), the processor may calculate the final offset based on the first offset slope, the reference offset, and the measured value of the grid power. That is, the processor may determine a first offset calculation function, which is a linear function having a certain slope and a certain y-intercept, and may compute the final offset based on the first offset calculation function. Accordingly, the final offset may be dynamically adjusted in response to a change in the grid power.

When the measured value of the grid power is negative (-), the processor may calculate the final offset based on the second offset slope, the reference offset, and the measured value of the grid power. That is, the processor may determine a second offset calculation function, which is a linear function having a certain slope and a certain y-intercept, and may compute the final offset based on the second offset calculation function. Accordingly, the final offset may be dynamically adjusted in response to a change in the grid power.

Finally, the processor may calculate the load power based on the measured value of the energy storage system power, the measured value of the grid power, and the final offset.

Although FIG. 7 illustrates a case in which it is determined whether to calculate an offset by either the first or second offset calculation function based on the sign of the measured value of the grid power in operation 760, but the present disclosure is not limited thereto. In other words, the selection criteria for the first and second offset calculation functions are not limited to the sign of the measured value of the grid power but may also include the sign of the measured value of the energy storage system power, the sign of the measured value of the photovoltaic system power, and the charge/discharge state of a battery.

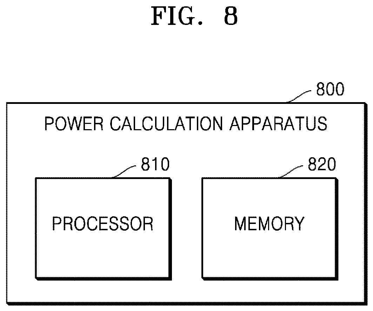

FIG. 8 is a block diagram of a power calculation apparatus according to an embodiment.

Referring to FIG. 8, a power calculation apparatus 800 may include a processor 810 and a memory 820. Only components related to the embodiment are shown in the power calculation apparatus 800 of FIG. 8. Accordingly, it will be understood by those skilled in the art that other general components may be included in addition to the components illustrated in FIG. 8. For example, although not shown in FIG. 8, the power calculation apparatus 800 may include a communication unit, which receives voltage or current sensing information that is basic information for obtaining power, and an interface which enables interaction with a user.

The processor 810 may general control operations of the power calculation apparatus 800. For example, the processor 810 may generally control the components of the power calculation apparatus 800 by executing programs stored in the memory 820. The processor 810 may also control the operations of the power calculation apparatus 800 by executing programs stored in the memory 820.

The processor 810 may control at least some of the operations of the power calculation apparatus described above with reference to FIGS. 1 to 7. For example, the processor 810 may obtain a measured value of grid power and a measured value of energy storage system power and may control at least a part of an operation of calculating an offset between the measured value of the grid power and the measured value of the energy storage system power by controlling the output power of an energy storage system and calculating load power based on the measured value of the grid power, the measured value of the energy storage system power, and the offset.

A specific example of the operation of the processor 810 has been described above with reference to FIGS. 1 to 7. Therefore, detailed descriptions of the operation of the processor 810 are omitted below.

The processor 810 may be implemented using at least one of application specific integrated circuits (ASICs), digital signal processors (DSPs), digital signal processing devices (DSPDs), programmable logic devices (PLDs), field programmable gate arrays

(FPGAs), controllers, micro-controllers, microprocessors, and electrical units performing other functions.

In an embodiment, the power calculation apparatus 800 may be a mobile electronic device. For example, the power calculation apparatus 800 may be implemented in a smartphone, a tablet personal computer (PC), a PC, a smart television (TV), a personal digital assistant (PDA), a laptop, a media player, a navigation device, a camera-equipped device, and other mobile electronic devices. In some embodiments, the power calculation apparatus 800 may be implemented in a wearable device, such as a watch, glasses, a hair band, or a ring, each being equipped with a communication function and a data processing function.

In some embodiments, the power calculation apparatus 800 may be an electronic device embedded in the circuitry of a power supply system. For example, the power calculation apparatus 800 may be an electronic device that is inserted into the circuitry of the power supply system through tuning after a production process. Specifically, according to an embodiment, the power calculation apparatus 800 may correspond to the distribution panel 15 in FIG.1., the main controller 34 or the distribution panel 35 in FIG. 3.

In some embodiments, the power calculation apparatus 800 may be a server outside the power supply system. The server may be implemented by one or more computer devices that communicate over a network to provide commands, codes, files, content, services, etc.

In some embodiments, a process performed in the power calculation apparatus 800 may be performed by at least some of a mobile electronic device, an electronic device embedded in a secondary battery manufacturing facility, and a server outside the secondary battery manufacturing facility.

An embodiment of the present invention may be embodied as a computer program executed on a computer using various components The computer program may be recorded in a computer-readable medium. At this time, the computer-readable medium may include a magnetic medium such as a hard disk, a floppy disk, or magnetic tape, an optical recording medium such as compact disc read-only memory (CD-ROM) or digital versatile disc (DVD), a magneto-optical medium such as a floptical disk, or a hardware device, such as ROM, random access memory (RAM), or flash memory, which is specifically configured to store and execute program instructions.

The computer program may be specially designed and configured for the present invention or may have been known and available to those skilled in the art in the field of computer software. Examples of computer programs may include machine codes created by a compiler and high-level language codes that may be executed on a computer using an interpreter.

According to an embodiment, a method according to various embodiments of the present disclosure may be provided as included in a computer program product. The computer program product may be traded between a seller and a buyer as a commodity. The computer program product may be distributed as a machine-readable storage medium (e.g., a CD-ROM) or may be distributed online (e.g., downloading or uploading) via an application store (e.g., Play StoreTM) or directly between two user devices. In the case of online distribution, at least a portion of the computer program product may be temporarily stored or temporarily created in a machine-readable storage medium, such as memory of a manufacturer's server, an application store's server, or a proxy server.

The operations of the method described herein can be performed in any suitable order unless otherwise indicated herein or otherwise clearly contradicted by context. The present invention is not necessarily limited to the described order of the operations. The use of any or all examples or example language provided herein is intended merely to elaborate the present invention and does not pose a limitation on the scope of the present invention unless otherwise claimed. Numerous modifications and adaptations will be readily apparent to one of ordinary skill in the art without departing from the spirit and scope of the appended claims or their equivalents.

Therefore, the spirit of the present invention should not be limited to the embodiments described above, and the scope of the appended claims and the scope of equivalents of the claims or the equivalently modified scope are all included in the spirit of the present invention.

According to the problem solving means of the present disclosure described above, the power of a load may be calculated without a separate load power measuring device by utilizing an interrelationship among the power of an energy storage system of a power supply system, the power of a grid, and the power of a load. Accordingly, design costs may be reduced, and system design may be simplified.

According to the problem solving means of the present disclosure described above, by compensating for various errors that may occur in relation to measurement of energy storage system power and grid power, a correction method increasing the accuracy of calculating load power may be provided. For example, the accuracy of load power calculation may be increased by compensating for offsets caused by factors, such as a measurement error occurring due to a precision limitation of measuring equipment, noise caused by electronic interference within a system, and residual impedance in a circuit of the power supply system.

**Claims**

1. A method of calculating load power of a power supply system, the method comprising:

obtaining a measured value of grid power and a measured value of energy storage system power;

computing an offset between the measured value of the grid power and the measured value of the energy storage system power by controlling output power of the energy storage system; and

calculating the load power based on the measured value of the grid power, the measured value of the energy storage system power, and the offset.

2. The method of claim 1, wherein

the measured value of the energy storage system power includes

a sum of a measured value of power output from at least one power conversion module included in the energy storage system.

3. The method of claim 1, wherein

the power supply system includes

at least one photovoltaic system,

wherein the method further comprises

obtaining a measured value of photovoltaic system power,

and

the calculating of the load power includes

calculating the load power based on the measured value of the grid power, the measured value of the energy storage system power, the measured value of the photovoltaic system power, and the offset.

4. The method of claim 3, wherein

the measured value of the photovoltaic system power includes

a sum of a measured value of power of the at least one photovoltaic system.

5. The method of claim 1, wherein

the computing of the offset includes:

obtaining a reference offset by controlling the output power of the energy storage system to 0;

obtaining a first offset by controlling the output power of the energy storage system to a maximum value and a second offset by controlling the output power of the energy storage system to a minimum value; and

computing the offset based on the reference offset, the first offset, the second offset, and the measured value of the grid power.

6. The method of claim 5, wherein

the obtaining of the reference offset includes:

cutting off an electrical connection between the power supply system and the load by controlling at least one switching element included in the power supply system; and

obtaining, as the reference offset, the measured value of the grid power when the output power of the energy storage system is 0.

7. The method of claim 5, wherein

the power supply system includes

at least one photovoltaic system, and

the obtaining of the reference offset includes:

cutting off an electrical connection between the power supply system and the load and an electrical connection between the power supply system and the at least one photovoltaic system by controlling at least one switching element included in the power supply system; and

obtaining, as the reference offset, the measured value of the grid power when the output power of the energy storage system is 0.

8. The method of claim 5, wherein

the obtaining of the first offset and the second offset includes:

cutting off an electrical connection between the power supply system and the load by controlling at least one switching element included in the power supply system;
obtaining, as the first offset, a difference between the measured value of the grid power and the output power of the energy storage system when the output power of the energy storage system is at the maximum value; and
obtaining, as the second offset, a difference between the measured value of the grid power and the output power of the energy storage system when the output power of the energy storage system is at the minimum value.

9. The method of claim 5, wherein

the power supply system includes
at least one photovoltaic system, and
the obtaining the first offset and the second offset includes:

cutting off an electrical connection between the power supply system and the load and an electrical connection between the power supply system and the at least one photovoltaic system by controlling at least one switching element included in the power supply system;
obtaining, as the first offset, a difference between the measured value of the grid power and the output power of the energy storage system when the output power of the energy storage system is at the maximum value; and
obtaining, as the second offset, a difference between the measured value of the grid power and the output power of the energy storage system when the output power of the energy storage system is at the minimum value.

10. The method of claim 5, wherein
the computing of the offset includes:

determining a first offset calculation function based on the reference offset and the first offset;
determining a second offset calculation function based on the reference offset and the second offset; and
computing the offset based on the first offset calculation function when the measured value of the grid power is positive or computing the offset based on the second offset calculation function when the measured value of the grid power is negative.

11. A computer-readable recording medium having recorded thereon a program for causing a computer to execute the method of claim 1.

12. A controller comprising:

a memory storing at least one program; and
a processor operating by executing the at least one program,
wherein the processor is configured to:

obtain a measured value of grid power and a measured value of energy storage system power;
compute an offset between the measured value of the grid power and the measured value of the energy storage system power by controlling output power of the energy storage system; and
calculate the load power based on the measured value of the grid power, the measured value of the energy storage system power, and the offset.

13. The controller of claim 12, wherein
the processor is further configured to:

obtain a reference offset by controlling the output power of the energy storage system to 0;
obtain a first offset by controlling the output power of the energy storage system to a maximum value and a second offset by controlling the output power of the energy storage system to a minimum value; and
compute the offset based on the reference offset, the first offset, the second offset, and the measured value of the grid power.

**14.** The controller of claim 13, wherein
the processor is further configured to:

cut off an electrical connection between a power supply system and the load and an electrical connection between the power supply system and a photovoltaic system by controlling at least one switching element included in the power supply system; and
obtain, as the reference offset, the measured value of the grid power when the output power of the energy storage system is 0.

**15.** The controller of claim 13, wherein
the processor is further configured to:

cut off an electrical connection between a power supply system and the load and an electrical connection between the power supply system and a photovoltaic system by controlling at least one switching element included in the power supply system;
obtain, as the first offset, a difference between the measured value of the grid power and the output power of the energy storage system when the output power of the energy storage system is at the maximum value; and
obtain, as the second offset, a difference between the measured value of the grid power and the output power of the energy storage system when the output power of the energy storage system is at the minimum value.

# FIG. 1

FIG. 2

FIG. 3

# FIG. 4

```
                    ( START )
                         |
                         v
+-------------------------------------------+
|  OBTAIN MEASURED VALUE OF GRID POWER AND  |—— 410
| MEASURED VALUE OF ENERGY STORAGE SYSTEM POWER |
+-------------------------------------------+
                         |
                         v
+-------------------------------------------+
| COMPUTE OFFSET BETWEEN MEASURED VALUE OF GRID |
|  POWER AND MEASURED VALUE OF ENERGY STORAGE   |—— 420
| SYSTEM POWER BY CONTROLLING  OUTPUT POWER OF  |
|          ENERGY STORAGE SYSTEM                |
+-------------------------------------------+
                         |
                         v
+-------------------------------------------+
| CALCULATE LOAD POWER BASED ON MEASURED VALUE  |
| OF GRID POWER, MEASURED VALUE OF ENERGY STORAGE |—— 430
|         SYSTEM POWER, AND OFFSET              |
+-------------------------------------------+
                         |
                         v
                    ( END )
```

# FIG. 5

# FIG. 6

**FIG. 7**

START

TURN OFF RELAY OF LOAD AND RELAY OF PHOTOVOLTAIC SYSTEM — 710

$P_{ESS} = 0,$
$Offset_{default} = P_{Grid}$ — 720

$P_{ESS} = (P_{ESS})_{max,}$
$Offset_{max} = P_{ESS} - P_{grid,}$
$Offset\_slope\_1 = (offset_{max} - offset_{default})/(P_{ESS})_{max}$ — 730

$P_{ESS} = (P_{ESS})_{min,}$
$Offset_{min} = P_{ESS} - P_{grid,}$
$Offset\_slope\_2 = (offset_{min} - offset_{default})/(P_{ESS})_{min}$ — 740

TURN ON RELAY OF LOAD AND RELAY OF PHOTOVOLTAIC SYSTEM — 750

760
$P_{grid} > 0?$

Y

N

770
$Final\_offset = offset_{default} - offset\_slope\_1*(P_{Grid})_{now,}$
$P_{load} = P_{ESS} + P_{PV} - P_{grid} + final\_offset$

780
$Final\_offset = offset_{default} + offset\_slope\_2*(P_{Grid})_{now,}$
$P_{load} = P_{ESS} + P_{PV} - P_{grid} + final\_offset$

# FIG. 8

POWER CALCULATION APPARATUS 800

PROCESSOR 810

MEMORY 820

Europäisches
Patentamt
European
Patent Office
Office européen
des brevets

# EUROPEAN SEARCH REPORT

**Application Number**

EP 25 22 1362

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/067948 A1 (SHON SANG-KI [KR]) 9 March 2017 (2017-03-09) * paragraph [0029] - paragraph [0076]; figures 2,3 * | 1-15 | INV. H02J3/46 ADD. H02J3/32 |
| X | US 2016/294322 A1 (PARK HUN [KR] ET AL) 6 October 2016 (2016-10-06) * paragraph [0072] - paragraph [0092]; figures 6, 7 * * paragraph [0108] - paragraph [0121]; figure 10 * * paragraph [0132] - paragraph [0139]; figure 12 * | 1-15 | H02J3/38 |
| A | US 2011/145611 A1 (LEE KANGWON [KR]) 16 June 2011 (2011-06-16) * paragraph [0052] - paragraph [0067]; figure 7 * | 1-15 | |

**TECHNICAL FIELDS SEARCHED (IPC)**

H02J

The present search report has been drawn up for all claims

| Place of search | Date of completion of the search | Examiner |
|---|---|---|
| Munich | 23 April 2026 | Mäki-Mantila, Harri |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 1362

This annex lists the patent family members relating to the patent documents cited in the above-mentioned European search report.
The members are as contained in the European Patent Office EDP file on
The European Patent Office is in no way liable for these particulars which are merely given for the purpose of information.

23-04-2026

| Patent document cited in search report | Publication date | Patent family member(s) | | Publication date |
|---|---|---|---|---|
| US 2017067948 A1 | 09-03-2017 | CN | 106501596 A | 15-03-2017 |
| | | EP | 3141916 A1 | 15-03-2017 |
| | | JP | 6194081 B2 | 06-09-2017 |
| | | JP | 2017051087 A | 09-03-2017 |
| | | KR | 20170028220 A | 13-03-2017 |
| | | US | 2017067948 A1 | 09-03-2017 |
| US 2016294322 A1 | 06-10-2016 | CN | 106053934 A | 26-10-2016 |
| | | EP | 3076134 A1 | 05-10-2016 |
| | | ES | 2790629 T3 | 28-10-2020 |
| | | JP | 6208780 B2 | 04-10-2017 |
| | | JP | 2016197988 A | 24-11-2016 |
| | | KR | 20160118538 A | 12-10-2016 |
| | | US | 2016294322 A1 | 06-10-2016 |
| US 2011145611 A1 | 16-06-2011 | KR | 20110068433 A | 22-06-2011 |
| | | US | 2011145611 A1 | 16-06-2011 |

EPO FORM P0459

For more details about this annex : see Official Journal of the European Patent Office, No. 12/82